# EUROPEAN PATENT APPLICATION

(11) **EP 3 500 080 A1**
(43) Date of publication of application: **19.06.2019**
(21) Application number: 17208219.0
(22) Date of filing: 18.12.2017
(51) Int. Cl.: H05K 9/00

(54) **ELECTRONIC APPARATUS WITH INTEGRAL HOUSING**

(71) Applicant: Microelectronics Technology Inc., Hsinchu 300 (TW)
(72) Inventor: LIU, Cheng-Hung, 300 TAIWAN, R.O.C. (TW); HUANG, Yu-Hui, 300 TAIWAN, R.O.C. (TW)
(74) Representative: 2K Patentanwälte Blasberg Kewitz & Reichel

(57) **Abstract**

An electronic apparatus includes a housing and a connector. The housing has an outer surface, an inner surface, an aperture extending from the outer surface to the inner surface, and a plurality of shielding walls disposed on the inner surface and adjacent to the aperture. The connector has a cage body with a plurality of spring arms configured to abut against the shielding walls of the housing.

## Description

### TECHNICAL FIELD

The present disclosure relates to an electronic apparatus with an integral housing, and more particularly, to an electronic apparatus with an integral housing structure implementing an electromagnetic interference shielding and an electrical grounding.

### DISCUSSION OF THE BACKGROUND

In many electronic apparatus, including computer apparatus, a large number of electronic components, which make up the computer apparatus, are generally arranged on one or more circuit boards. Typically, these circuit boards are arranged in parallel within a housing. With the increased use of electronic products in the office environment, electromagnetic interference ("EMI") has become an important consideration in the design of such products. Various techniques have been proposed for using the housing to shield electrical components on printed circuit boards in order to limit the emission of EMI created by electronic products, or to protect such products from external sources of EMI that could affect their operation.

This Discussion of the Background section is provided for background information only. The statements in this Discussion of the Background are not an admission that the subject matter disclosed in this Discussion of the Background section constitutes prior art to the present disclosure, and no part of this Discussion of the Background section may be used as an admission that any part of this application, including this Discussion of the Background section, constitutes prior art to the present disclosure.

### SUMMARY

One aspect of the present disclosure provides an electronic apparatus with an integral housing structure implementing an electromagnetic interference shielding and an electrical grounding.

In some embodiments of the present disclosure, an electronic apparatus comprises a housing and a connector, wherein the housing has an outer surface, an inner surface, an aperture extending from the outer surface to the inner surface, and a plurality of shielding walls disposed on the inner surface and adjacent to the aperture, and wherein the connector has a cage body with a plurality of spring arms configured to abut against the shielding walls of the housing.

In some embodiments of the present disclosure, the shielding walls are integrally formed with the housing and extend from the inner surface.

In some embodiments of the present disclosure, the electronic apparatus further comprises a circuit board disposed in the housing, wherein the connector is disposed on the circuit board.

In some embodiments of the present disclosure, the shielding walls are vertically disposed on the inner surface.

In some embodiments of the present disclosure, the connector is disposed between the shielding walls.

In some embodiments of the present disclosure, the connector has a slot in the cage body, and the slot faces the aperture.

In some embodiments of the present disclosure, the electronic apparatus further comprises a cable gland configured to engage with the housing.

In some embodiments of the present disclosure, a housing comprises an outer surface, an inner surface, an aperture extending from the outer surface to the inner surface, and a plurality of shielding walls disposed on the inner surface and adjacent to the aperture, wherein the shielding walls are integrally formed with the housing and extend from the inner surface.

In some embodiments of the present disclosure, a housing comprises a housing body and a plurality of shielding walls disposed on the housing body, wherein the housing body has an outer surface, an inner surface, and an aperture extending from the outer surface to the inner surface, wherein the plurality of shielding walls are disposed on the inner surface and adjacent to the aperture, wherein the shielding walls and the housing body are made of the same material and have substantially the same electrical potential.

In some embodiments of the present disclosure, the shielding walls and the housing body are integrally formed, i.e., made of the same material and having substantially the same electrical potential. Consequently, galvanic corrosion due to a potential difference is not likely to occur in the housing, particularly between the shielding walls and the housing body.

In some embodiments of the present disclosure, the cage body with the spring arms is electrically connected to the ground of the circuit board. The abutting of the spring arms against the shielding walls of the housing not only implements the grounding of the housing, but also implements the electromagnetic interference (EMI) shielding of the housing. In some embodiments of the present disclosure, the size and the position of the shielding walls can be redesigned according to the size of the connector, without considering other external components.

The foregoing has outlined rather broadly the features and technical advantages of the present disclosure in order that the detailed description of the disclosure that follows may be better understood. Additional features and advantages of the disclosure will be described hereinafter, and form the subject of the claims of the disclosure. It should be appreciated by those skilled in the art that the conception and specific embodiment disclosed may be readily utilized as a basis for modifying or designing other structures or processes for carrying out the same purposes of the present disclosure. It should also be realized by those skilled in the art that such equivalent constructions do not depart from the spirit and scope of the disclosure as set forth in the appended claims.

### BRIEF DESCRIPTION OF THE DRAWINGS

A more complete understanding of the present disclosure may be derived by referring to the detailed description and claims when considered in connection with the Figures, where like reference numbers refer to similar elements throughout the Figures, and:
FIG. 1 is an assembled view of an electronic apparatus according to some embodiments of the present disclosure.
FIG. 2 and FIG. 3 are disassembled views of the electronic apparatus in FIG. 1 from different view angles according to some embodiments of the present disclosure.
FIG. 4 is an assembled view of an electronic apparatus according to a comparative embodiment of the present disclosure.
FIG. 5 and FIG. 6 are disassembled views of the electronic apparatus in FIG. 4 from different view angles according to some embodiments of the present disclosure.

### DETAILED DESCRIPTION

The following description of the disclosure accompanies drawings, which are incorporated in and constitute a part of this specification, and illustrate embodiments of the disclosure, but the disclosure is not limited to the embodiments. In addition, the following embodiments can be properly integrated to complete another embodiment.

References to "some embodiments," "an embodiment," "exemplary embodiment," "other embodiments," "another embodiment," etc. indicate that the embodiment(s) of the disclosure so described may include a particular feature, structure, or characteristic, but not every embodiment necessarily includes the particular feature, structure, or characteristic. Further, repeated use of the phrase "in the embodiment" does not necessarily refer to the same embodiment, although it may.

The present disclosure is directed to an electronic apparatus with an integral housing structure implementing an electromagnetic interference shielding and an electrical grounding. In order to make the present disclosure completely comprehensible, detailed steps and structures are provided in the following description. Obviously, implementation of the present disclosure does not limit special details known by persons skilled in the art. In addition, known structures and steps are not described in detail, so as not to limit the present disclosure unnecessarily. Preferred embodiments of the present disclosure will be described below in detail. However, in addition to the detailed description, the present disclosure may also be widely implemented in other embodiments. The scope of the present disclosure is not limited to the detailed description, and is defined by the claims.

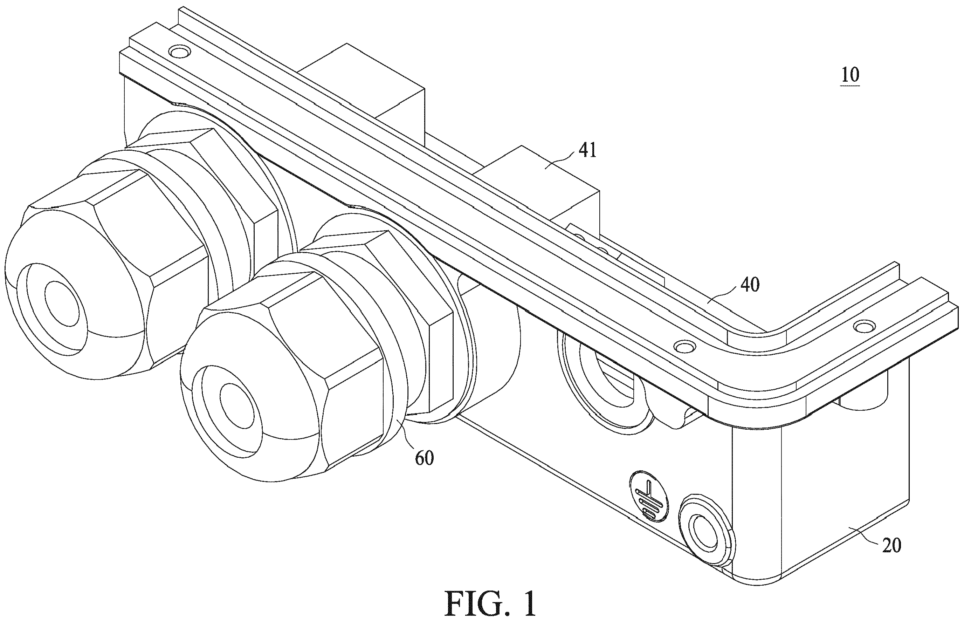

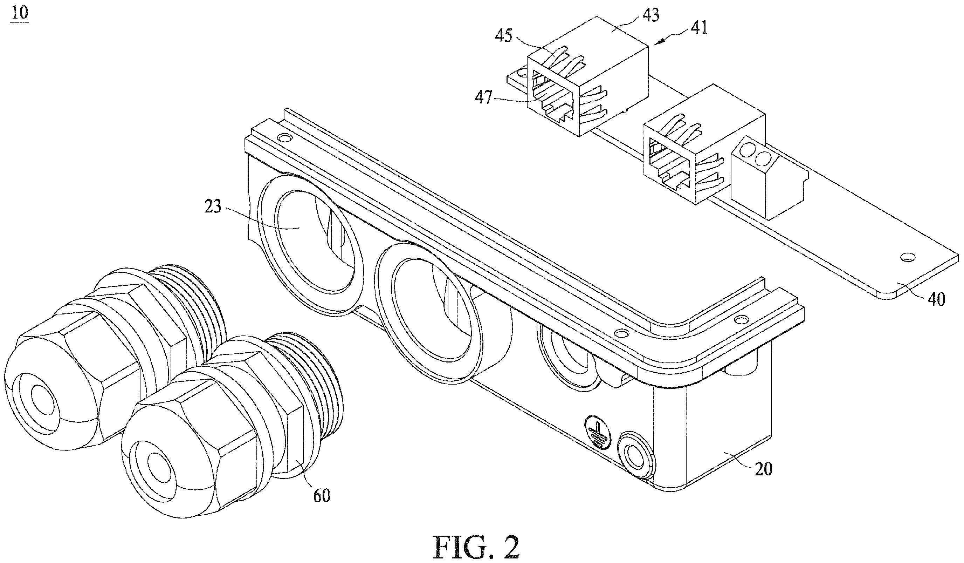

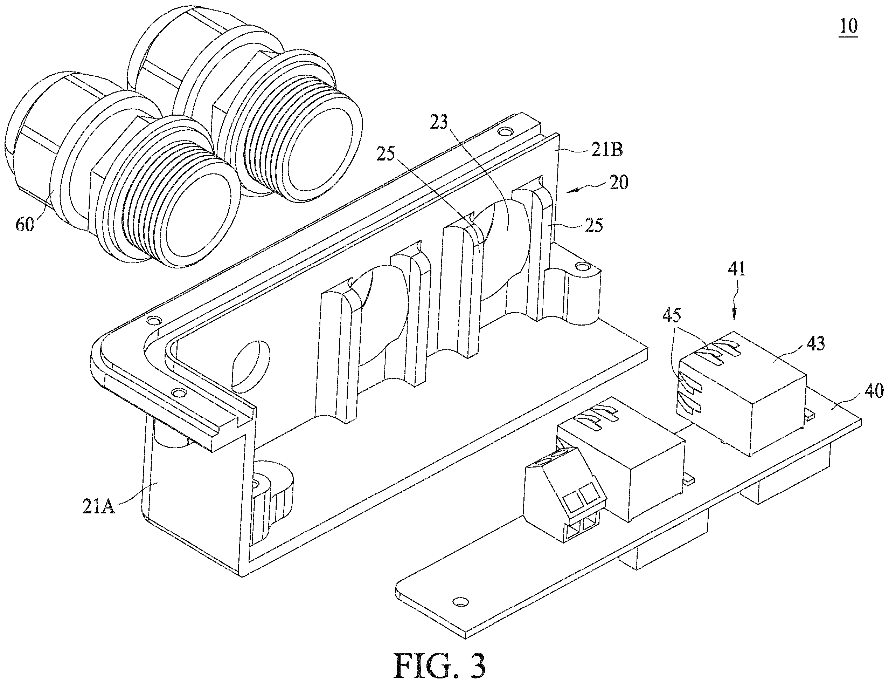

FIG. 1 is an assembled view of an electronic apparatus 10 according to some embodiments of the present disclosure, and FIG. 2 and FIG. 3 are disassembled views of the electronic apparatus 10 in FIG. 1 from different view angles according to some embodiments of the present disclosure. In some embodiments of the present disclosure, the electronic apparatus 10 comprises a housing 20, a circuit board 40 with a connector 41 thereon, and a cable gland 60 configured to engage with the housing 20. In some embodiments of the present disclosure, the circuit board 40 is a printed circuit board (PCB) disposed in the housing 20, and the connector 41 is an electrical connector disposed on and electrically connected to the circuit board 40.

In some embodiments of the present disclosure, the housing 20 has a housing body 21 with an outer surface 21A and an inner surface 21B, an aperture 23 extending from the outer surface 21A to the inner surface 21B, and a plurality of shielding walls 25 disposed on the inner surface 21B and adjacent to the aperture 23. In some embodiments of the present disclosure, the connector 41 has a cage body 43 with a plurality of spring arms 45 configured to abut against the shielding walls 25 of the housing 20.

In some embodiments of the present disclosure, the shielding walls 25 are integrally formed with the housing 20 and extend from the inner surface 21B. In some embodiments of the present disclosure, the shielding walls 25 are vertically disposed on the inner surface 21B, and the connector 41 is disposed between the shielding walls 25. In some embodiments of the present disclosure, the connector 41 has a slot 47 in the cage body 43, and the slot 47 faces the aperture 23 of the housing 20.

In some embodiments of the present disclosure, the slot 47 serves as a female receptacle for receiving a male plug; the cable gland 60 includes a first hollow-cylindrical portion, a second hollow-cylindrical portion, and a flange between the first hollow-cylindrical portion and the second hollow-cylindrical portion. In some embodiments of the present disclosure, the male plug such as the registered jack (RJ) may include a spring latch that is latched by a lower portion of the slot (the female receptacle) 47 when the male plug connects to the female receptacle of the connector 41.

In some embodiments of the present disclosure, the shielding walls 25 and the housing body 21 are integrally formed, i.e., made of the same material and having substantially the same electrical potential. Consequently, galvanic corrosion due to a potential difference is not likely to occur in the housing 20, particularly between the shielding walls 25 and the housing body 21.

In some embodiments of the present disclosure, the cage body 43 with the spring arms 45 is electrically connected to the ground of the circuit board 40. Furthermore, the abutting of the spring arms 45 against the shielding walls 25 of the housing 20 not only implements grounding of the housing 20, but also implements electromagnetic interference (EMI) shielding of the housing 20. In some embodiments of the present disclosure, the size and the position of the shielding walls 25 can be redesigned according to the size of the connector 41, without considering other external components.

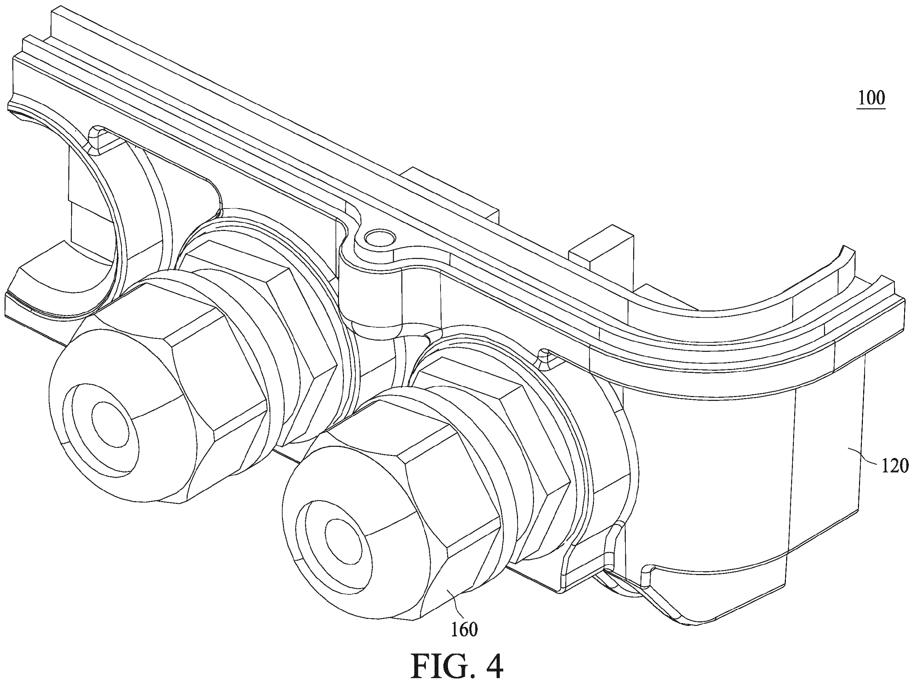

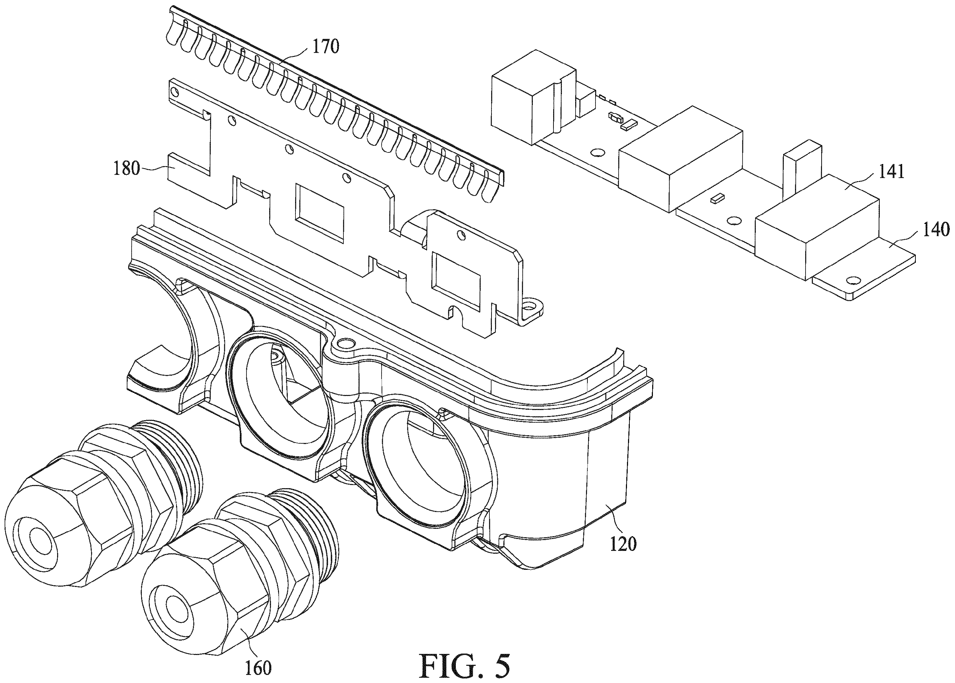

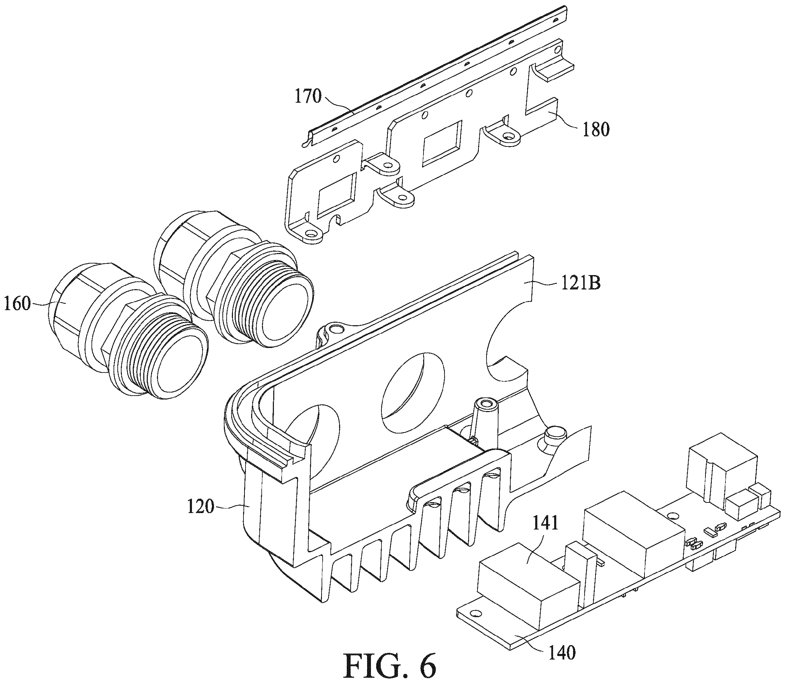

FIG. 4 is an assembled view of an electronic apparatus 100 according to a comparative embodiment of the present disclosure, and FIG. 5 and FIG. 6 are disassembled views of the electronic apparatus 100 in FIG. 4 from different view angles according to a comparative embodiment of the present disclosure. In some comparative embodiments, the electronic apparatus 100 comprises a housing 120, a circuit board 140 with a connector 141 thereon, and a cable gland 160 configured to engage with the housing 120.

The inner surface 121B is substantially flat without protrusions. To implement the EMI shielding, the electronic apparatus 100 further includes a metal interposer 170 and a metal front panel 180, which are generally made of conductive material different from that of the housing 120. Consequently, galvanic corrosion due to the potential difference between dissimilar materials is likely to occur in the comparative electronic apparatus 100, particularly between the housing body 120 and the metal interposer 170, and between the housing body 120 and the metal front panel 180.

In addition, as compared to the electronic apparatus 10 in FIG. 1, the comparative electronic apparatus 100 in FIG. 4 includes two more components, the metal interposer 170 and the metal front panel 180, and the overall cost of the comparative electronic apparatus 100 in FIG. 4 is correspondingly higher than that of the electronic apparatus 10 in FIG. 1.

Furthermore, current electronic apparatus are getting smaller and smaller, and the space therein is becoming correspondingly narrower and narrower. Consequently, assembling the additional components (the metal interposer 170 and the metal front panel 180) with the housing 120 is not easy and take more and more assembling hours as the size of the electronic apparatus is reduced.

In some embodiments of the present disclosure, an electronic apparatus comprises a housing and a connector, wherein the housing has an outer surface, an inner surface, an aperture extending from the outer surface to the inner surface, and a plurality of shielding walls disposed on the inner surface and adjacent to the aperture, and wherein the connector has a cage body with a plurality of spring arms configured to abut against the shielding walls of the housing.

In some embodiments of the present disclosure, a housing comprises an outer surface, an inner surface, an aperture extending from the outer surface to the inner surface, and a plurality of shielding walls disposed on the inner surface and adjacent to the aperture, wherein the shielding walls are integrally formed with the housing and extend from the inner surface.

In some embodiments of the present disclosure, a housing comprises a housing body and a plurality of shielding walls disposed on the housing body, wherein the housing body has an outer surface, an inner surface, and an aperture extending from the outer surface to the inner surface, wherein the plurality of shielding walls are disposed on the inner surface and adjacent to the aperture, and wherein the shielding walls and the housing body are made of the same material and have substantially the same electrical potential.

Although the present disclosure and its advantages have been described in detail, it should be understood that various changes, substitutions and alterations can be made herein without departing from the spirit and scope of the disclosure as defined by the appended claims. For example, many of the processes discussed above can be implemented in different methodologies and replaced by other processes, or a combination thereof.

Moreover, the scope of the present application is not intended to be limited to the particular embodiments of the process, machine, manufacture, composition of matter, means, methods and steps described in the specification. As one of ordinary skill in the art will readily appreciate from the disclosure of the present disclosure, processes, machines, manufacture, compositions of matter, means, methods, or steps, presently existing or later to be developed, that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps.

## Claims

1. An electronic apparatus, comprising:
a housing having an outer surface, an inner surface, an aperture extending from the outer surface to the inner surface, and a plurality of shielding walls disposed on the inner surface and adjacent to the aperture; and
a connector having a cage body with a plurality of spring arms configured to abut against the shielding walls of the housing.

2. The electronic apparatus of Claim 1, wherein the shielding walls are integrally formed with the housing and extend from the inner surface.

3. The electronic apparatus of Claim 1 or 2, further comprising a circuit board disposed in the housing, wherein the connector is disposed on the circuit board.

4. The electronic apparatus of any of the Claims 1 to 3, wherein the shielding walls are vertically disposed on the inner surface.

5. The electronic apparatus of Claim 4, wherein the connector is disposed between the shielding walls.

6. The electronic apparatus of any of the Claims 1 to 5, wherein the connector has a slot in the cage body, and the slot faces the aperture.

7. The electronic apparatus of any of the Claims 1 to 6, further comprising a cable gland configured to engage with the housing.

8. A housing, comprising an outer surface, an inner surface, an aperture extending from the outer surface to the inner surface, and a plurality of shielding walls disposed on the inner surface and adjacent to the aperture, wherein the shielding walls are integrally formed with the housing and extend from the inner surface.

9. The housing of Claim 8, wherein the shielding walls are vertically disposed on the inner surface.

10. A housing, comprising a housing body and a plurality of shielding walls disposed on the housing body,
wherein the housing body has an outer surface, an inner surface, and an aperture extending from the outer surface to the inner surface,
wherein the plurality of shielding walls are disposed on the inner surface and adjacent to the aperture, and
wherein the shielding walls and the housing body are made of the same material and have substantially the same electrical potential.

11. The housing of Claim 10, wherein the shielding walls are vertically disposed on the inner surface.
